# FASCICULE DE BREVET EUROPEEN

(11) **EP 1 178 500 B1**
(45) Date de publication et mention de la délivrance du brevet: **09.09.2009**
(21) Numéro de dépôt: 01410093.7
(22) Date de dépôt: 23.07.2001
(51) Int. Cl.: H01F 17/00, H01L 23/64, H01F 21/12

(54) **Structure intégrée d'inductances à valeurs partagées sur un substrat semiconducteur**
Induktive integrierte Struktur mit geteilten Werten auf einem Halbleitersubstrat
Inductive integrated structure with split values on a semiconductor substrate

(30) Priorité: 31.07.2000 FR 0010066
(43) Date de publication de la demande: 06.02.2002
(73) Titulaire: STMicroelectronics S.A., 92120 Montrouge (FR)
(72) Inventeur: Castillejo, Armand, 38000 Grenoble (FR); Rerat, Fabienne, 38000 Grenoble (FR)
(74) Mandataire: de Beaumont, Michel

(56) Documents cités:
- EP-A- 0 940 826
- DE-A- 3 941 323
- US-A- 5 892 425
- CHEUNG D T S ET AL: "MONOLITHIC TRANSFORMERS FOR SILICON RF IC DESIGN" MELECON CONFERENCES,US,NEW YORK, NY: IEEE, 18 mai 1998 (1998-05-18), pages 105-108, XP000802034 ISBN: 0-7803-3880-4

## Description

La présente invention concerne des inductances à valeurs partagées formées sur un substrat semiconducteur, et en particulier de telles inductances destinées à fonctionner dans une gamme de fréquences supérieures à plusieurs centaines de MHz, que l'on appellera ici gamme RF.

Le brevet américain US-A-5 892 425 décrit un système d'inductances à point milieu comportant des pistes semiconductrices distinctes disposées selon des spirales imbriquées.

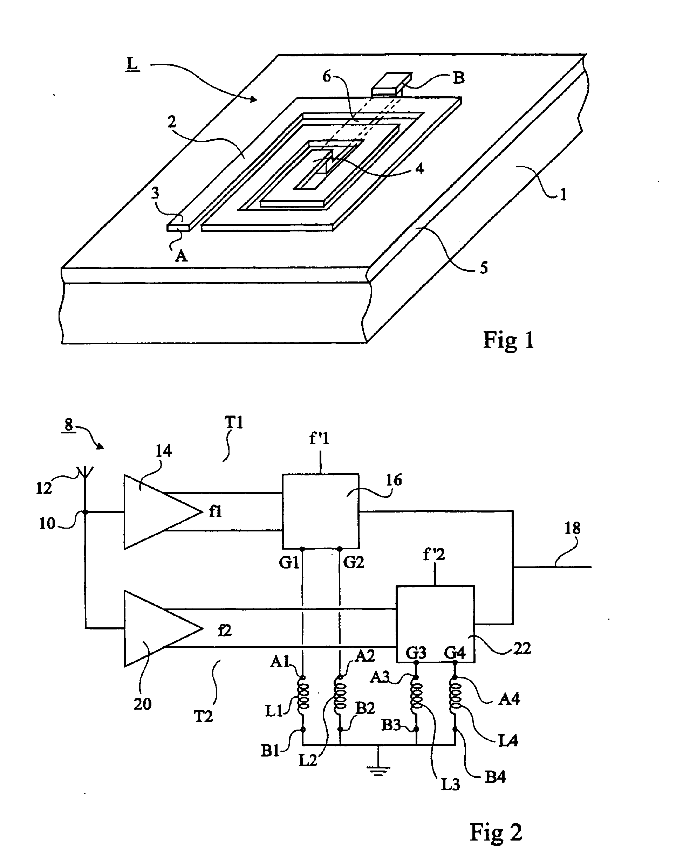

La figure 1 représente schématiquement une vue en perspective d'une inductance L intégrée sur un substrat semiconducteur 1, destinée à fonctionner dans la gamme RF. L'inductance L comprend une piste conductrice 2 sensiblement plane déposée sur une première couche isolante 5 du substrat semiconducteur. La piste conductrice 2 forme un enroulement composé d'une succession de segments rectilignes disposés entre une première extrémité 3, du côté externe de l'enroulement et une seconde extrémité 4, du côté interne de l'enroulement. Les segments rectilignes constituant l'enroulement sont sensiblement parallèles deux à deux et séparés par une distance constante. Une première borne A de l'inductance L est constituée par l'extrémité 3 de la piste 2. Une seconde borne B de l'inductance L est reliée à l'extrémité 4 de la piste 2 par l'intermédiaire d'un segment conducteur 6 passant en dessous des segments de la piste 2.

La figure 2 représente schématiquement un circuit 8 de réception de signaux RF utilisant des inductances intégrées. Le circuit 8 comporte une première chaîne de traitement T1 permettant de recevoir des signaux modulés sur une porteuse de fréquence f1, par exemple de l'ordre de 900 MHz, et une seconde chaîne de traitement T2 permettant de recevoir des signaux modulés sur une porteuse de fréquence f2, par exemple de l'ordre de 1800 MHz. Un tel circuit est utilisable dans un appareil comme un téléphone portable prévu pour fonctionner soit uniquement avec la fréquence f1, soit uniquement avec la fréquence f2, soit indifféremment avec une des fréquences f1 ou f2.

Le circuit 8 comprend une entrée 10 connectée à une antenne 12. La première chaîne de traitement T1 comprend un amplificateur à faible bruit 14, un mélangeur 16 et un premier oscillateur local (non représenté). L'amplificateur 14, prévu pour amplifier des signaux modulés sur une porteuse de fréquence f1, est connecté à l'entrée 10 et fournit un signal différentiel au mélangeur 16. Le mélangeur 16 reçoit par ailleurs un signal sinusoïdal de fréquence f1' produit par le premier oscillateur local. Il fournit un signal de fréquence intermédiaire IF = f1 - f1' à une sortie 18. La seconde chaîne de traitement T2 comprend un amplificateur à faible bruit 20, un mélangeur 22 et un second oscillateur local (non représenté). L'amplificateur 20, prévu pour amplifier des signaux modulés sur une porteuse de fréquence f2, est connecté à l'entrée 10 et fournit un signal différentiel au mélangeur 22. Le circuit 22 reçoit aussi un signal sinusoïdal de fréquence f2' produit par le second oscillateur local et fournit un signal de fréquence intermédiaire IF = f2 - f2' à la sortie 18, les fréquences intermédiaires fournies par les mélangeurs 16 et 22 étant les mêmes. Un moyen de commande (non représenté) active une des chaînes de traitement en fonction de la fréquence souhaitée.

Le mélangeur 16 comprend une cellule dite "cellule de Gilbert" (non représentée) dont des bornes G1 et G2 sont connectées respectivement aux premières bornes A1, A2 de deux inductances L1 et L2. Les secondes bornes B1 et B2 des inductances L1 et L2 sont reliées à la masse du circuit. Les inductances L1 et L2 sont de valeur égale. Lorsque la cellule de Gilbert fonctionne, les courants alternatifs qui traversent les inductances L1 et L2 ont la même fréquence, la même valeur absolue, et sont de sens inverse. La valeur des inductances L1 et L2 est inversement proportionnelle à la fréquence de fonctionnement.

De même, le mélangeur 22 comprend une cellule de Gilbert (non représentée) dont deux bornes G3 et G4 sont connectées respectivement aux premières bornes A3, A4 de deux inductances L3 et L4. Les secondes bornes B3, B4 des inductances L3 et L4 sont reliées à la masse du circuit. Les inductances L3 et L4 sont de valeur égale. La fréquence f2 étant supérieure à la fréquence f1, les inductances L3, L4 ont une valeur inférieure à celle des inductances L1, L2.

Dans une réalisation sous forme intégrée du circuit 8, les quatre inductances L1, L2 et L3, L4 occupent une surface importante, ce qui accroît le coût du circuit intégré.

Un objet de la présente invention est de prévoir une structure d'inductances occupant une surface réduite sur un substrat semi-conducteur.

Pour atteindre cet objet, ainsi que d'autres, la présente invention prévoit un circuit intégré comprenant une structure d'inductances sur un substrat semiconducteur, destinée à fonctionner à des fréquences supérieures à plusieurs centaines de MHz, comportant une première inductance formée par une piste conductrice et présentant des première et deuxième bornes reliées respectivement à chacune des deux extrémités de la piste conductrice, comprenant une deuxième inductance formée par la piste conductrice entre la deuxième borne et un point intermédiaire quelconque de la piste conductrice relié à une troisième borne, lesdites deuxième et troisième bornes constituant les deux bornes de la deuxième inductance, et des moyens pour mettre la troisième borne à haute impédance quand la première inductance est utilisée.

Selon un mode de réalisation de la présente invention, la piste conductrice est formée de segments rectilignes.

Selon un mode de réalisation de la présente invention, la piste conductrice est sensiblement de forme octogonale.

Selon un mode de réalisation de la présente invention, ledit point intermédiaire est relié à la troisième borne par l'intermédiaire d'un segment conducteur rectiligne.

Selon un mode de réalisation de la présente invention, ledit segment conducteur est sensiblement perpendiculaire à la piste conductrice.

Selon un mode de réalisation de la présente invention, le circuit comprend au moins une deuxième structure d'inductances symétrique de la première structure et formée des mêmes éléments, dans lequel les pistes conductrices des première et deuxième structures sont imbriquées l'une dans l'autre de sorte que les deux pistes conductrices sont de même longueur, et dans lequel les distances de chacun des points intermédiaires de chacune des pistes conductrices des première et deuxième structures d'inductances à la deuxième extrémité desdites pistes conductrices sont égales.

Selon un mode de réalisation de la présente invention, le circuit comprend des première et deuxième chaînes de traitement, la première chaîne comportant un premier mélangeur propre à utiliser une première fréquence et la deuxième chaîne comportant un deuxième mélangeur propre à utiliser une deuxième fréquence, la première borne de la première inductance étant reliée au premier mélangeur, la deuxième borne de la première inductance étant reliée à une masse du circuit, et la troisième borne de la deuxième inductance étant reliée au deuxième mélangeur.

Selon un mode de réalisation de la présente invention, le circuit comprend une deuxième structure d'inductances identique à la première structure, la première borne de la première inductance de la deuxième structure étant reliée au premier mélangeur, la deuxième borne de la première inductance de la deuxième structure étant reliée à la masse du circuit, et la troisième borne de la deuxième inductance de la deuxième structure étant reliée au deuxième mélangeur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente une vue en perspective d'une inductance classique ;
la figure 2, précédemment décrite, représente schématiquement un circuit utilisant plusieurs inductances ;
la figure 3 représente schématiquement une vue de dessus d'une structure d'inductances selon la présente invention ;
la figure 4 représente schématiquement un circuit utilisant la structure d'inductances selon la présente invention ;
la figure 5 représente schématiquement une vue de dessus d'une première variante de la présente invention ; et
la figure 6 représente schématiquement une vue de dessus d'une deuxième variante de la présente invention.

Seuls les éléments susceptibles de faciliter la compréhension de la présente invention ont été représentés. De mêmes références représentent de mêmes éléments aux diverses figures.

La présente invention prévoit de réaliser un circuit intégré comprenant une structure d'inductances comportant une première inductance formée d'une piste conductrice, et une deuxième inductance formée entre une extrémité de la piste conductrice et un point quelconque de la piste conductrice, relié à une borne par un segment conducteur de liaison. Ainsi, un circuit bi-bande comme le circuit 8 pourra utiliser soit la première inductance, soit la deuxième inductance selon son mode de fonctionnement.

Une telle structure d'inductances suppose la connexion d'un segment conducteur en un point intermédiaire quelconque de la première inductance. Or, il existe chez l'homme du métier un fort préjugé selon lequel la connexion d'un tel segment conducteur crée des problèmes insurmontables. Notamment, l'homme du métier du domaine des fréquences RF pensait qu'un segment conducteur relié à un point quelconque de la première inductance accroîtrait de manière difficilement quantifiable la capacité parasite de la piste formant la première inductance. Or, un accroissement de la capacité parasite d'une inductance diminue la fréquence de résonance d'un circuit incorporant cette inductance. En outre, l'homme du métier considérait que la présence d'un point intermédiaire de connexion entraînerait l'apparition d'un couplage électromagnétique dû aux éléments parasites modifiés entre le segment conducteur et la piste conductrice, susceptible de modifier la valeur des inductances de manière difficilement quantifiable.

Un apport des inventeurs a été de faire des essais et de remarquer que la modification des fréquences de résonance des première et deuxième inductances selon la présente invention par les segments de piste conductrice inutilisés est en fait négligeable si les première et deuxième inductances ne sont pas utilisées simultanément, et si les extrémités des segments de piste inutilisés, et au moins celle du segment conducteur relié au point intermédiaire, sont maintenues en haute impédance.

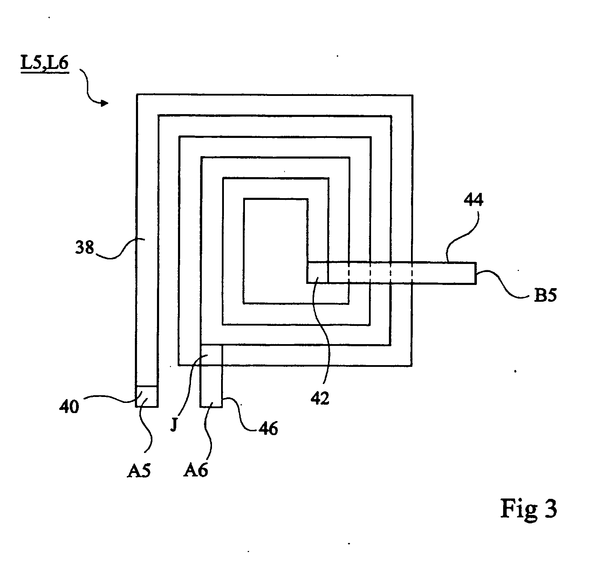

La figure 3 représente schématiquement une vue de dessus d'une structure d'inductances L5, L6 selon la présente invention. L'inductance L5 comprend une piste conductrice 38 formant un enroulement composé d'une succession de segments rectilignes entre une première extrémité 40, du côté externe de l'enroulement et une seconde extrémité 42, du côté interne de l'enroulement. Une première borne A5 de l'inductance L5 est constituée par la première extrémité 40 de la piste 38. Une seconde borne B5 de l'inductance L5 est reliée à la seconde extrémité de la piste 38 par l'intermédiaire d'un premier segment conducteur 44. Selon la présente invention, une inductance L6 est formée par la partie de la piste conductrice 38 située entre l'extrémité 42 et un point J prédéterminé de la piste 38. Un second segment conducteur 46 permet de connecter le point J à une première borne A6 de l'inductance L6. De préférence, le segment conducteur 46 est sensiblement perpendiculaire aux segments de la piste 38. La seconde borne de l'inductance L6 est constituée par la borne B5.

La demanderesse a constaté que, même dans la gamme RF, le couplage existant entre le segment conducteur 46 et la piste 38 a une influence négligeable sur la valeur de l'inductance L5 lorsque la borne A6 est maintenue en haute impédance.

La structure d'inductances L5, L6 selon la présente invention occupe sensiblement la même surface que l'inductance L5 toute seule, ce qui représente un gain de surface considérable. Cette structure s'applique à tout circuit utilisant une seule des deux inductances L5, L6 à un instant dans lequel la borne de l'inductance inutilisée peut être maintenue à haute impédance.

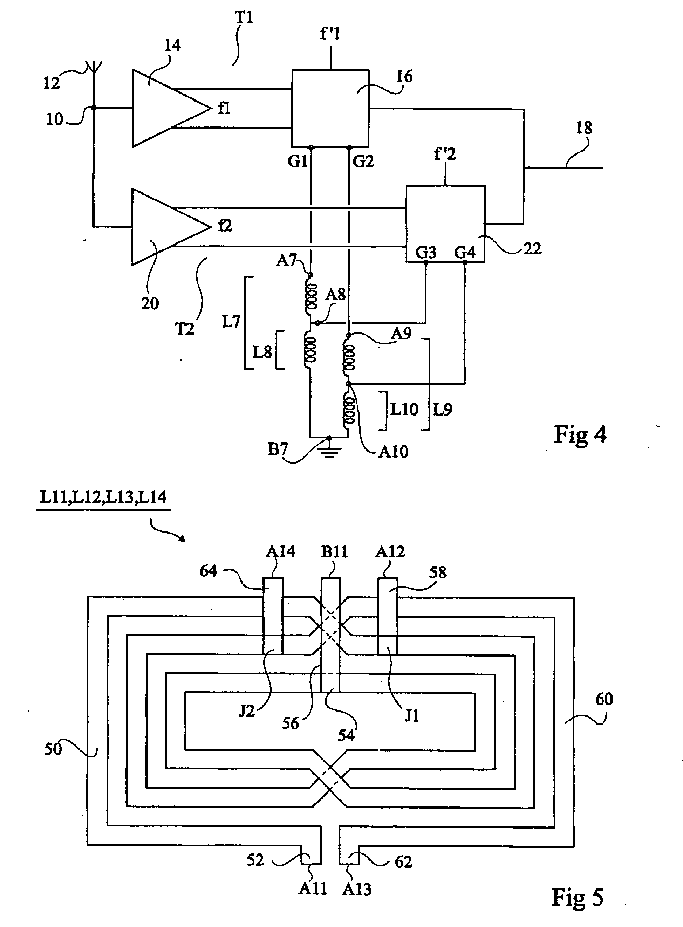

La figure 4 illustre un circuit bi-bande similaire à celui de la figure 2, dans lequel de mêmes références désignent de mêmes éléments.

Deux structures d'inductances selon la présente invention L7, L8 d'une part et L9, L10 d'autre part, remplacent les inductances L1, L3 et L2, L4 du circuit de la figure 2. La borne G1 du mélangeur 16 est connectée à la première borne, A7, de l'inductance L7. La seconde borne, B7, de l'inductance L7 est reliée à la masse. La borne G3 du mélangeur 22 est connectée à la première borne, A8, de l'inductance L8. De même, la borne G2 du mélangeur 16 est connectée à la première borne, A9, de l'inductance L9. La seconde borne de l'inductance L9 est reliée à la masse. La borne G4 du mélangeur 22 est connectée à la première borne, A10, de l'inductance L10.

Lorsque la première chaîne de traitement est utilisée, le mélangeur 16 est activé et le mélangeur 22 est inactivé. Les inductances L7 et L9 sont alors utilisées. Les bornes G3, G4 du mélangeur 22, inactivé, sont en haute impédance. De même, lorsque la seconde chaîne de traitement est utilisée, le mélangeur 22 est activé et le mélangeur 16 est inactivé. Les inductances L8 et L10 sont utilisées. Les bornes G1, G2 du mélangeur 16, inactivé, sont alors en haute impédance.

La surface occupée par les structures d'inductances L7, L8 et L9, L10 selon la présente invention est sensiblement deux fois inférieure à la surface occupée par les inductances L1, L2, L3 et L4.

La figure 5 représente schématiquement une vue de dessus d'un dispositif comprenant deux structures de deux inductances selon la présente invention, respectivement L11, L12 et L13, L14; symétriques et imbriquées l'une dans l'autre. La première inductance L11 comprend une piste conductrice 50 formée d'une succession de segments rectilignes disposés selon un enroulement entre une première extrémité 52, du côté externe de l'enroulement et une seconde extrémité 54, du côté interne de l'enroulement. La première borne A11 de l'inductance L11 est constituée par l'extrémité 52 de la piste 50. La seconde borne B11 de l'inductance L11 est reliée à l'extrémité 54 de la piste 50 par l'intermédiaire d'un segment conducteur 56.

L'inductance L12 est formée par la partie de la piste conductrice 50 située entre l'extrémité 54 et un point J1 prédéterminé de la piste 50. Un segment conducteur 58 permet de connecter le point J1 à une première borne A12 de l'inductance L12. La seconde borne de l'inductance L12 est constituée par la borne B11.

L'inductance L13 comprend une piste conductrice 60 formée d'une succession de segments rectilignes disposés selon un enroulement symétrique par rapport à l'enroulement de la piste conductrice 50. Les segments de la piste 60 croisent les segments de la piste 50 en plusieurs points, par un chevauchement sans contact. Les pistes 50, 60 ont la même longueur et les inductances L11 et L13 ont la même valeur. La piste 60 comprend une première extrémité 62, du côté externe de l'enroulement et une seconde extrémité constituée par la seconde extrémité 54 de la piste 50. La première borne A13 de l'inductance L13 est constituée par l'extrémité 62 de la piste 60. La seconde borne de l'inductance L13 est commune avec la seconde borne B11 de l'inductance L11.

L'inductance L14 est formée par la partie de la piste conductrice 60 située entre l'extrémité 54 et un point J2 prédéterminé de la piste 60. Un segment conducteur 64 permet de connecter le point J2 à une première borne A14 de l'inductance L14. La seconde borne de l'inductance L14 est constituée par la borne B11.

Une telle disposition des pistes 50 et 60 peut être utilisée dans le circuit de la figure 2. Ainsi, les deux inductances. L11, L13 peuvent être utilisées pour remplacer les inductances L1 et L2 tandis que les deux inductances L12 et L14 peuvent être utilisées pour remplacer les inductances L3 et L4. En outre, la proximité des bornes A11 et A13 facilite la connexion du couple d'inductances L11 et L13 respectivement aux bornes G1 et G2 du mélangeur 16 par des pistes de même longueur et de même impédance. De même, la proximité des bornes A12 et A14 facilite la connexion du couple d'inductances L12 et L14 respectivement aux bornes G3 et G4 du mélangeur 22.

Bien entendu, la présente invention est susceptible de diverses variantes et modifications qui apparaîtront à l'homme du métier. Ainsi, on a décrit l'utilisation d'une structure d'inductances selon la présente invention dans un circuit récepteur bi-bande tel que le circuit de la figure 4. Bien entendu, on peut utiliser la structure d'inductances selon la présente invention dans un circuit émetteur bi-bande et, de manière générale, dans tout circuit comportant deux inductances utilisées non simultanément.

En outre, bien que l'on ait, pour des raisons de clarté, représenté en figures 3 et 5 des inductances selon la présente invention dont l'enroulement a une forme sensiblement carrée ou rectangulaire, l'homme du métier adaptera sans difficulté la présente invention à des inductances dont l'enroulement a une forme quelconque.

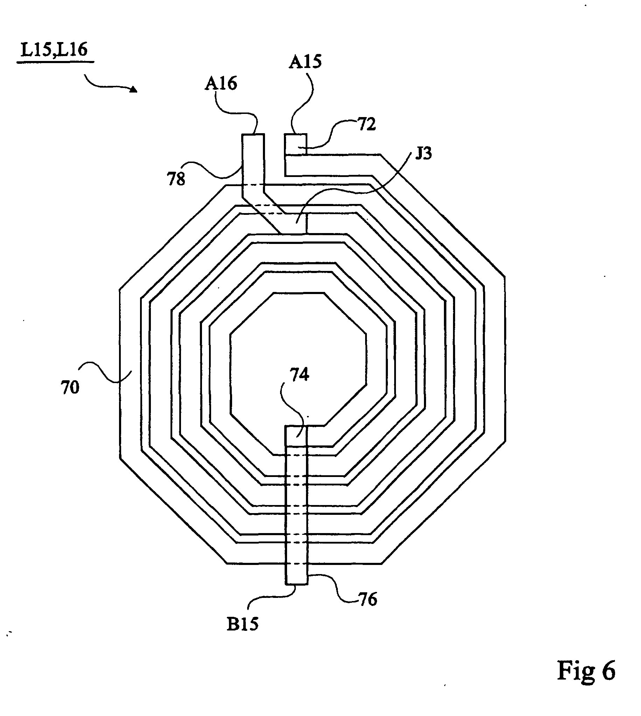

A titre d'exemple, la figure 6 représente une structure d'inductances L15, L16 selon la présente invention, dont la piste conductrice 70 a une forme sensiblement octogonale entre une première extrémité 72, du côté externe de l'enroulement et une seconde extrémité 74, du côté interne de l'enroulement. Une première borne A15 de l'inductance L15 est constituée par la première extrémité 72 de la piste 70. Une seconde borne B15 de l'inductance L15 est reliée à la seconde extrémité 74 de la piste 70 par l'intermédiaire d'un segment conducteur 76. L'inductance L16 est formée par la partie de la piste conductrice 70 située entre l'extrémité 74 et un point J3. Un second segment conducteur 78 permet de connecter le point J3 à une première borne A16 de l'inductance L16. La seconde borne de l'inductance L16 est constituée par la borne B15.

Dans la description précédente, la seconde inductance des structures d'inductances selon la présente invention est formée par la partie de la piste conductrice située entre la seconde borne de la première inductance et un point prédéterminé. Cependant, l'homme du métier adaptera sans difficulté la présente invention au cas où la seconde inductance est formée par la partie de la piste conductrice située entre la première borne et ledit point prédéterminé.

Seules ont été décrites des structures d'inductances selon la présente invention utilisant une piste conductrice et comportant deux inductances, la deuxième inductance étant formée entre un point prédéterminé de la piste conductrice et une extrémité de la piste conductrice. Le préjugé écartant la possibilité du branchement d'un segment conducteur en un point quelconque de la piste conductrice ayant été vaincu, on pense qu'il est possible d'adapter la présente invention à une structure comportant trois inductances ou plus, chaque inductance étant formée entre un point prédéterminé particulier de la piste conductrice et une extrémité de la piste conductrice.

## Revendications

1. Circuit intégré comprenant une structure d'inductances sur un substrat semiconducteur, destinée à fonctionner à des fréquences supérieures à plusieurs centaines de MHz, comportant une première inductance (L5) formée par une piste conductrice (38) et présentant des première (A5) et deuxième (B5) bornes reliées respectivement à chacune des deux extrémités (40, 42) de la piste conductrice, **caractérise en ce qu'**il comprend :
une deuxième inductance (L6) formée par la piste conductrice (38) entre la deuxième borne (B5) et un point intermédiaire quelconque (J) de la piste conductrice relié à une troisième borne (A6), lesdites deuxième et troisième bornes constituant les deux bornes de la deuxième inductance, et
des moyens pour mettre la troisième borne (A6) à haute impédance quand la première inductance (L5) est utilisée.

2. Circuit selon la revendication 1, dans lequel la piste conductrice (38) est formée de segments rectilignes.

3. Circuit selon la revendication 2, dans lequel la piste conductrice (70) est sensiblement de forme octogonale.

4. Circuit selon la revendication 1, dans lequel ledit point intermédiaire est relié à la troisième borne par l'intermédiaire d'un segment conducteur rectiligne (46).

5. Circuit selon la revendication 4, dans lequel ledit segment conducteur (46) est sensiblement perpendiculaire à la piste conductrice.

6. Circuit selon l'une quelconque des revendications 1 à 5, comprenant au moins une deuxième structure d'inductances symétrique de la première structure et formée des mêmes éléments, dans lequel les pistes conductrices (50 ; 60) des première et deuxième structures sont imbriquées l'une dans l'autre de sorte que les deux pistes conductrices sont de même longueur, et dans lequel les distances de chacun des points intermédiaires (J1 ; J2) de chacune des pistes conductrices (50 ; 60) des première et deuxième structures d'inductances à la deuxième extrémité desdites pistes conductrices sont égales.

7. Circuit selon l'une quelconque des revendications 1 à 5, comprenant des première et deuxième chaînes de traitement (T1, T2), la première chaîne (T1) comportant un premier mélangeur (16) propre à utiliser une première fréquence (f1) et la deuxième chaîne (T2) comportant un deuxième mélangeur (22) propre à utiliser une deuxième fréquence (f2), la première borne de la première inductance étant reliée au premier mélangeur, la deuxième borne de la première inductance étant reliée à une masse du circuit, et la troisième borne de la deuxième inductance étant reliée au deuxième mélangeur.

8. Circuit selon la revendication 7, comportant une deuxième structure d'inductances identique à la première structure, la première borne de la première inductance de la deuxième structure étant reliée au premier mélangeur, la deuxième borne de la première inductance de la deuxième structure étant reliée à la masse du circuit, et la troisième borne de la deuxième inductance de la deuxième structure étant reliée au deuxième mélangeur.

## Claims

1. An integrated circuit including a structure of inductances on a semiconductor substrate, intended for operating at frequencies greater than several hundreds of MHz, including: a first inductance (L5) formed by a conductive track (38) and having first (A5) and second (B5) terminals respectively connected to each of the two ends (40, 42) of the conductive track, **characterized in that** it comprises:
a second inductance (L6) formed by the conductive track (38) between the second terminal (B5) and any intermediate point (J) of the conductive track connected to a third terminal (A6), said second and third terminals forming the two terminals of the second inductance, and
means for setting the third terminal (A6) to high impedance when the first inductance (L5) is used.

2. The circuit of claim 1, wherein the conductive track (38) is formed of rectilinear segments.

3. The circuit of claim 2, wherein the conductive track (70) is substantially of octagonal shape.

4. The circuit of claim 1, wherein said intermediary point is connected to the third terminal via a rectilinear conductive segment (46).

5. The circuit of claim 4, wherein said conductive segment (46) is substantially perpendicular to the conductive track.

6. The circuit of any of claims 1 to 5, including at least one second inductance structure symmetrical to the first structure and formed of the same elements, wherein the conductive tracks (50; 60) of the first and second structures are interleaved so that the two conductive tracks have the same length, and wherein the distances from each of the intermediary points (J1; J2) of each of the conductive tracks (50; 60) of the first and second inductance structures to the second end of said conductive tracks are equal.

7. The circuit of any of claims 1 to 5, including first and second processing chains (T1, T2), the first chain (T1) including a first mixer (16) adapted to using a first frequency (f1) and the second chain (T2) including a second mixer (22) adapted to using a second frequency (f2), the first terminal of the first inductance being connected to the first mixer, the second terminal of the first inductance being connected to a circuit ground, and the third terminal of the second inductance being connected to the second mixer.

8. The circuit of claim 7, including a second inductance structure identical to the first structure, the first terminal of the first inductance of the second structure being connected to the first mixer, the second terminal of the first inductance of the second structure being connected to the circuit ground, and the third terminal of the second inductance of the second structure being connected to the second mixer.

## Patentansprüche

1. Eine integrierte Schaltung, die eine Struktur von Induktivitäten auf einem Halbleitersubstrat beinhaltet, zum Betrieb bei Frequenzen, die größer als mehrere hundert MHz sind, wobei die Schaltung beinhaltet: eine erste Induktivität (L5), gebildet durch eine leitende Spur (38) und erste (A5) bzw. zweite (B5) Anschlüsse, die mit beiden Enden (40, 42) der leitenden Spur verbunden sind, **dadurch gekennzeichnet dass** die Schaltung Folgendes aufweist:
eine zweite Induktivität (L6), gebildet durch die leitende Spur (38) zwischen dem zweiten Anschluss (B5) und irgendeinem dazwischenliegenden Punkt (J) der leitenden Spur, verbunden mit einem dritten Anschluss (A6), wobei die zweiten und dritten Anschlüsse die zwei Anschlüsse der zweiten Induktivität bilden, und
Mittel zum Einstellen des dritten Anschlusses (A6) auf hohe Impedanz, wenn die erste Induktivität (L5) genutzt wird.

2. Schaltung nach Anspruch 1, wobei die leitende Spur (38) aus geradlinigen Segmenten gebildet ist.

3. Schaltung nach Anspruch 2, wobei die leitende Spur (70) im Wesentlichen eine oktagonale Form besitzt.

4. Schaltung nach Anspruch 1, wobei der dazwischenliegende Punkt mit dem dritten Anschluss über ein geradliniges leitendes Segment (46) verbunden ist.

5. Schaltung nach Anspruch 4, wobei das leitende Segment (46) im Wesentlichen senkrecht zu der leitenden Spur ist.

6. Schaltung nach irgendeinem der Ansprüche 1 bis 5, wenigstens eine zweite induktive Struktur beinhaltend, und zwar symmetrisch zu der ersten Struktur und aus den gleichen Elementen gebildet, wobei die leitenden Spuren (50; 60) von den ersten und zweiten Strukturen so interleavt bzw. verschachtelt sind, dass die zwei leitenden Spuren die gleiche Länge besitzen, und wobei die Distanzen von jedem der dazwischenliegenden Punkten (J1, J2) von jeder der leitenden Spuren (50; 60) von den ersten und zweiten induktiven Strukturen zu dem zweiten Ende der leitenden Spuren gleich sind.

7. Schaltung nach irgendeinem der Ansprüche 1 bis 5, einschließlich erster und zweiter Verarbeitungsketten (T1, T2), wobei die erste Kette (T1) einen ersten Mischer (16) beinhaltet, der angepasst ist zum Nutzen einer ersten Frequenz (f1) und die zweite Kette (T2) einen zweiten Mischer (22) beinhaltet, der angepasst ist zum Nutzen einer zweiten Frequenz (f2), wobei der erste Anschluss der ersten Induktivität mit dem ersten Mischer verbunden ist, der zweiten Anschluss der ersten Induktivität mit einer Schaltkreismasse verbunden ist, und der dritte Anschluss der zweiten Induktivität mit dem zweiten Mischer verbunden ist.

8. Schaltung nach Anspruch 7, einschließlich einer zweiten induktiven Struktur, die mit der ersten Struktur identisch ist, wobei der erste Anschluss der ersten Induktivität der zweiten Struktur mit dem ersten Mischer verbunden ist, der zweite Anschluss der ersten Induktivität der zweiten Struktur mit der Schaltkreismasse verbunden ist, und der dritte Anschluss der zweiten Induktivität der zweiten Struktur mit dem zweiten Mischer verbunden ist.
